(19) Europäisches Patentamt
European Patent Office
Office européen des brevets

(11) **EP 2 961 250 A1**

(12) **EUROPÄISCHE PATENTANMELDUNG**

(43) Veröffentlichungstag:
**30.12.2015 Patentblatt 2015/53**

(51) Int Cl.:
*H05K 1/02* [(2006.01)]     *F21V 29/00* [(2015.01)]

(21) Anmeldenummer: **15173100.7**

(22) Anmeldetag: **22.06.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(30) Priorität: **24.06.2014 DE 202014102862 U**

(71) Anmelder: **Zumtobel Lighting GmbH**
**6850 Dornbirn (AT)**

(72) Erfinder:
• **Favarolo, Angelo**
**88239 Wangen i.A. (DE)**
• **Kohler, Michael**
**6850 Dornbirn (AT)**
• **Kottek, Thomas**
**6890 Lustenau (AT)**
• **Olariu, Cristian**
**6850 Dornbirn (AT)**
• **Peter, Norbert**
**6845 Hohenems (AT)**
• **Schubnell, Sebastian**
**88079 Kressbronn (DE)**
• **Skergeth, Sascha**
**6890 Lustenau (AT)**
• **Steurer, Daniel**
**6952 Sibratsgfäll (AT)**

(74) Vertreter: **Thun, Clemens**
**Mitscherlich PartmbB**
**Patent- und Rechtsanwälte**
**Sonnenstraße 33**
**80331 München (DE)**

(54) **ANORDNUNG ZUR LICHTABGABE MIT LED UND TRÄGERELEMENT**

(57) Bei einer Anordnung zur Lichtabgabe (50) mit mindestens einem Leuchtmittel in Form einer LED (2) sowie einem Trägerelement (1), an dessen Oberfläche die LED (2) angeordnet ist, ist das Trägerelement (1) durch eine Mehrschicht-Leiterplatte gebildet, welche aus einem elektrisch isolierenden Basismaterial (20) sowie mehreren Kupferschichten (25) besteht, von denen zumindest eine in das Basismaterial (20) eingebettet ist und als Wärmeleiter dient.

Fig. 1

EP 2 961 250 A1

**Beschreibung**

Die vorliegende Erfindung betrifft eine Anordnung zur Lichtabgabe, welche mindestens ein Leuchtmittel in Form einer LED sowie ein Trägerelement aufweist, an dessen Oberfläche die LED angeordnet ist.

Auf Halbleiterelementen basierende Leuchtmittel in Form von LEDs haben sich zwischenzeitlich in allen Bereichen der Beleuchtungstechnologie durchgesetzt. Aufgrund der zwischenzeitlich erreichten deutlichen Steigerung ihrer Effizienz können LEDs nicht mehr lediglich zur Anzeigezwecken genutzt werden sondern kommen allgemein in der Raumbeleuchtung zum Einsatz. Mittlerweile werden auch Leuchten zur Straßenbeleuchtung vertrieben, welche LEDs als Lichtquellen beinhalten.

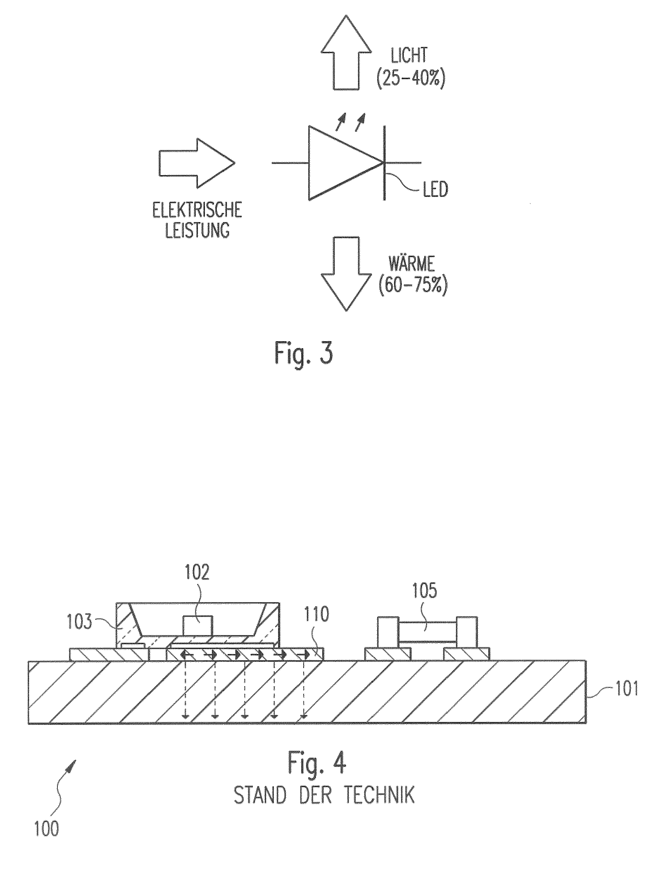

Wie auch andere Lichtquellen setzen LEDs die zugeführte elektrische Energie in Licht um, wobei die Umwandlung allerdings nicht zu 100% erfolgt sondern stattdessen ein gewisser Anteil der zugeführen Leistung als Verlustwärme abgegeben wird. Die Energiebilanz einer LED ist schematisch in Figur 3 gezeigt, wobei erkennbar ist, dass LEDs je nach Qualität die zugeführte Leistung zu etwa 25 bis 40% in Licht umsetzen, was wiederum bedeutet, dass ein verhältnismäßig hoher Anteil von 60 bis 75% in Wärme umgesetzt wird. Letztendlich hängt die Effizienz der Umsetzung in Licht von verschiedenen Faktoren wie beispielsweise der Farbe beziehungsweise der Farbtemperatur, dem Farbwiedergabeindex (CRI), der Stromdichte in der LED-Schaltungsanordnung sowie eventueller Alterungsprozesse ab.

Problematisch in diesem Zusammenhang ist, dass die Abmessungen von LEDs verhältnismäßig klein sind, also die Wärme sehr konzentriert in bestimmten Bereichen erzeugt wird. Diese Wärme wiederum kann zu einer Herabsetzung der Effizienz der LEDs und letztendlich auch zu einer Beeinträchtigung ihrer Lebensdauer führen. Bei hohen Temperaturen können auch Beschädigungen der LEDs nicht ausgeschlossen werden. LEDs sind deshalb im Vergleich zu klassischen Lichtquellen wie Glühbirnen oder Leuchtstofflampen deutlich temperatursensibler, weshalb es unerlässlich ist, eine effiziente Abführung der Wärme während des Betriebs zu gewährleisten, um optimale Betriebsbedingungen für die LEDs zur Verfügung zu stellen.

Üblicherweise werden LEDs auf flächigen Trägerelementen in Form von Platinen angeordnet. Dabei befinden sich auf den Leiterplatten oftmals auch noch weitere elektronische Komponenten, welche gemeinsam mit der Leiterplatte und den LEDs ein sogenanntes LED-Modul bilden.

Eine aus dem Stand der Technik bekannte Ausgestaltung eines LED-Moduls ist in Schnittdarstellung in Figur 4 gezeigt. Die allgemein mit dem Bezugszeichen 100 versehene Anordnung besteht aus der Leiterplatte 101, auf der zunächst die LEDs - dargestellt ist im vorliegenden Fall lediglich eine einzige LED 102 - sowie eventuell zugeordnete optische Komponenten 103 angeordnet sind. Wie bereits erwähnt, befinden sich üblicherweise auf der Platine 101 noch weitere elektronische Komponenten 105, über welche beispielsweise eine entsprechende Ansteuerung der LEDs 102 erfolgt.

Die Verbindung der LEDs 102 untereinander sowie gegebenenfalls zu den elektronischen Komponenten 105 erfolgt über Leiterbahnen, die üblicherweise durch eine auf der Oberfläche der Leiterplatte 101 ausgebildete und entsprechend strukturierte Kupferschicht 110 gebildet werden. Im Vergleich zu dem Material der Leiterplatte 101, welche beispielsweise durch FR-4 (mit Epoxidharz getränkte Glasfasermatten) gebildet wird, weist Kupfer eine hohe Wärmeleitfähigkeit auf. Um deshalb eine bessere Wärmeableitung zu ermöglichen, wird oftmals versucht, die Kontaktierungs- beziehungsweise Bestückungsbereiche der Leiterplatte 101, welche durch das Kupfer 110 gebildet werden, möglichst großflächig zu gestalten. Wie in Figur 4 schematisch dargestellt ist, wird durch das Kupfer 110 die Wärme über eine größere Fläche verteilt und über den darunterliegenden Bereich des Leiterplattenmaterials abgegeben.

Auf der anderen Seite sollen oftmals LED-Module möglichst kompakt gestaltet werden, was letztendlich die Möglichkeiten, die Flächen der Kupferbereiche zu vergrößern, limitiert. Dies gilt insbesondere für den Fall, dass auf der Leiterplatte 101 - wie in Figur 4 dargestellt - weitere elektronische Komponenten 105 positioniert werden, da diese zwangsläufig auch entsprechenden Platz benötigen. Da ferner neuartige Kontaktierungsverfahren für die LEDs sowie für die elektronischen Komponenten oftmals erfordern, dass die Leiterbahnen beziehungsweise die Kontaktierungsbereiche im Querschnitt gesehen sehr dünn ausgebildet sind, bedeutet dies, dass die auf der Oberfläche der Leiterplatte 101 zur Verfügung stehenden Kupferbereiche nur in einem gewissen Umfang zur effizienten Wärmeabfuhr genutzt werden können.

Insbesondere zur Realisierung von LED-Modulen kommen deshalb zwischenzeitlich oftmals sogenannte Metallkern-Leiterplatten zum Einsatz. Hierbei sind in das elektrisch isolierende Leiterplattenmaterial Metallkerne aus Aluminium eingebettet, welche eine verbesserte Wärmeableitung ermöglichen. Hierdurch können zwar zumindest teilweise die oben beschriebenen Probleme vermieden werden, allerdings sind derartige Metallkern-Leiterplatten deutlich kostenintensiver in ihrer Herstellung.

Der vorliegenden Erfindung liegt deshalb die Aufgabenstellung zugrunde, eine Möglichkeit anzubieten, LED-Module verhältnismäßig kostengünstig zu realisieren und trotz allem eine effiziente Ableitung der während des Betriebs auftretenden Wärme sicherzustellen.

Die Aufgabe wird durch eine Anordnung zur Lichtabgabe, welche die Merkmale des Anspruchs 1 aufweist, gelöst. Vorteilhafte Weiterbildungen der Erfindung sind Gegenstand der abhängigen Ansprüche.

Die erfindungsgemäße Lösung beruht auf dem Gedanken, als Trägerelement für die LEDs sog. Mehrschicht-Leiterplatten zu verwenden, welche aus einem elektrisch isolierenden Basismaterial sowie mehreren Kupferschichten bestehen, von denen zumindest eine in das Basismaterial eingebettet ist. Erfindungsgemäß wird insbesondere diese eingebettete Kupferschicht als Wärmeleiter genutzt, um die während des Betriebs auftretende Wärme der LEDs effizient flächig zu verteilen und an die Umgebung abzugeben.

Gemäß der vorliegenden Erfindung wird deshalb eine Anordnung zur Lichtabgabe mit mindestens einem Leuchtmittel in Form einer LED sowie einem Trägerelement vorgeschlagen, an dessen Oberfläche die LED angeordnet ist, wobei das Trägerelement durch eine Mehrschicht-Leiterplatte gebildet ist, welche aus einem elektrisch isolierenden Basismaterial sowie mehreren Kupferschichten besteht, von denen zumindest eine in das Basismaterial eingebettet ist und als Wärmeleiter dient.

Derartige Mehrschicht-Leiterplatten sind bereits bekannt, sie werden bislang allerdings nicht als Trägerelement für LED-Module eingesetzt sondern dienen der Realisierung komplexerer elektronischer Elemente. Hierbei werden die sich in verschiedenen Ebenen befindenden Kupferschichten als Leiterbahnen verwenden, um komplexere jedoch nach wie vor kompakte elektronische Schaltungen zu realisieren. Die verschiedenen Kupferschichten sind in diesem Fall durch vertikal bzw. quer verlaufende Verbindungen elektrisch miteinander verbunden. Derartige Maßnahmen könnten theoretisch auch bei der erfindungsgemäßen Anordnung vorgesehen sein, in erster Linie ist jedoch vorgesehen, dass die in das elektrisch isolierende Basismaterial eingebetteten Kupferschichten der Verteilung der während des Betriebs der LEDs auftretenden Wärme dienen. Es hat sich gezeigt, dass durch diese Maßnahme die Ableitung beziehungsweise Weiterleitung der Wärme deutlich gesteigert werden kann und dementsprechend die Bedingungen für einen effizienten LED-Betrieb verbessert werden. Gleichzeitig sind derartige Mehrschicht-Leiterplatten im Vergleich zu den oben erwähnten Metallkern-Leiterplatten kostengünstiger herzustellen.

Vorzugsweise sind zumindest zwei parallel zueinander verlaufende Kupferschichten in das elektrisch isolierende Basismaterial eingebettet. Dabei handelt es sich bei dem Basismaterial zum Beispiel um das derzeit verwendete Standardmaterial, nämlich FR-4.

Eine der Kupferschichten ist dabei ferner an der Oberfläche der Leiterplatte ausgebildet und entsprechend strukturiert, um Leiterbahnen zur Realisierung eines LED-Kreises zu bilden. Die Leiterbahnen können ferner auch dazu ausgebildet sein, weitere elektronische Komponenten mit den LEDs zu verbinden.

Auch an der den LEDs gegenüberliegenden Seite der Platine kann eine weitere Kupferschicht ausgebildet sein, welche dann unmittelbar einen mit der Umgebung in Kontakt stehenden Kühlkörper bildet. Diese bodenseitige Kupferschicht könnte darüber hinaus auch zu thermischen Ankopplung beispielsweise an weitere Kühlkörper genutzt werden.

Letztendlich können mit Hilfe der erfindungsgemäßen Lösung LED-Module realisiert werden, welche in ihrer Herstellung kostengünstig sind und für das vorgesehene Anwendungsgebiet ausreichend gute thermische Eigenschaften aufweisen.

Nachfolgend soll die Erfindung anhand der beiliegenden Zeichnung näher erläutert werden. Es zeigen:

Figur 1   ein erstes Ausführungsbeispiel einer erfindungsgemäßen Anordnung zur Lichtabgabe in Form eines LED-Moduls im Querschnitt;

Figur 2   ein zweites erfindungsgemäßes Ausführungsbeispiel einer Anordnung zur Lichtabgabe;

Figur 3   schematisch die Umsetzung der einer LED zugeführten Leistung in Licht und Wärme und

Figur 4   ein LED-Modul gemäß dem Stand der Technik.

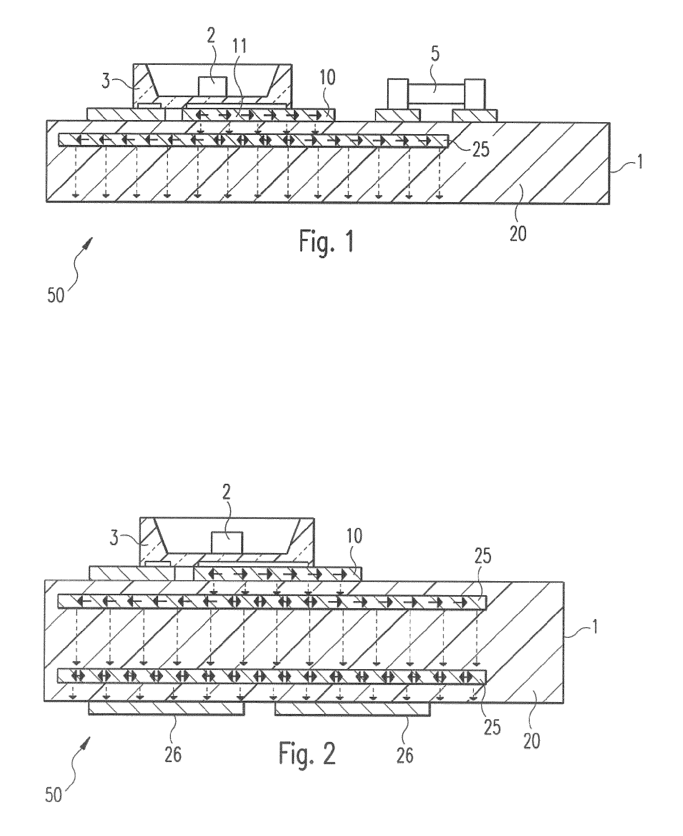

Figur 1 zeigt ein erstes Ausführungsbeispiel eines erfindungsgemäßen, allgemein mit dem Bezugszeichen 50 versehenen LED-Moduls, welches hinsichtlich seines grundsätzlichen Aufbaus sehr stark dem in Figur 4 dargestellten Modul 100 ähnelt. Das erfindungsgemäße Modul besteht also wiederum zunächst aus einer Leiterplatte 1, auf der zumindest eine LED 2 gegebenenfalls mit zugehöriger Optik 3 angeordnet ist. Bei dieser Optik 3 kann es sich wie dargestellt beispielsweise um Reflektoren und/oder Linsen handeln. Ferner können auf der Oberseite der Leiterplatte 1 zusätzliche elektronische Komponenten 5 angeordnet sein, die beispielsweise der Steuerung des LED-Betriebs dienen.

Die elektrische Verbindung der LEDs 2 untereinander sowie der elektronischen Komponenten 5 erfolgt über Leiterbahnen, welche aus Kupfermaterial 10 bestehen, das an der Oberfläche entsprechend strukturiert ausgebildet ist. Wie erkennbar ist, wird hierbei versucht, die Kontaktierungsbereiche 11 für die LEDs 2 möglichst großflächig auszubilden, um bereits an der Oberfläche eine möglichst großflächige Verteilung der während des Betriebs entstehenden Wärme zu erzielen.

Erfindungsgemäß wird die Leiterplatte 1 nunmehr durch eine Mehrschicht-Leiterplatte gebildet, welche aus einem Basismaterial 20 sowie darin eingebetteten Kupferschichten 25 besteht. Bei dem Basismaterial kann es sich um ein entsprechend geeignetes elektrisch isolierendes Material handeln, wobei derzeit standardmäßig FR-4 zum Einsatz kommt. In dieses Material, welches aus mit Epoxidharz getränkten Glasfasermatten besteht, sind dann die Kupferschichten 25 wie dargestellt eingebettet, wobei üblicherweise mehrere Kupferschichten vorhanden sind, welche normalerweise über quer - in der Darstellung also vertikal - verlaufende Verbindungen miteinander elektrisch verbunden sind, um komplexere Schaltkreise zu realisieren. Im vorliegenden Fall sind derartige elektrische Querverbindungen nicht unbedingt erforderlich, da mit Hilfe der Kupferschicht 25 primär eine verbesserte Wärmeableitung erzielt werden soll. Wie dargestellt, ist die Kupferschicht 25 möglichst in der Nähe der Oberseite der Leiterplatte 1, also der Seite, an der sich die LEDs 2 befinden, angeordnet. Nach Verteilung der während des Betriebs auftretenden Wärme - schematisch dargestellt durch die Pfeile - durch die aus Kupfer bestehenden Kontaktierungsbereiche 11 wird also die Wärme auf die in das Basismaterial 20 der Leiterplatte 10 eingebettete Kupferschicht 25 übertragen und dort über eine deutlich größere Fläche verteilt. Trotz der sehr geringen Wärmeleitfähigkeit des Basismaterials 20 der Leiterplatte 1 wird hierdurch die Ableitung der Wärme deutlich verbessert, wie ein Vergleich der Darstellungen von Figur 1 und Figur 4 unmittelbar zeigt.

Die verbesserte Effizienz bei der Wärmeabfuhr ergibt sich auch aus der nachfolgenden Gleichung, welche die Höhe des thermischen Widerstands der dargestellten Anordnung beschreibt:

$$Rth = d / A \cdot k$$

Rth entspricht hierbei dem thermischen Widerstand, während d der Wegstrecke durch das wärmeleitende Material entspricht. A entspricht der Fläche, über welche die Wärme weitergeleitet wird, und k entspricht dem Wärmeleitungskoeffizienten des Materials. Wird davon ausgegangen, dass bei den beiden Anordnungen gemäß den Figuren 1 und 4 jeweils das gleiche elektrisch isolierende Material zum Einsatz kommt, also der Parameter k jeweils identisch ist, so liegt also bei der erfindungsgemäßen Variante von Figur 1 in erster Linie eine deutliche Vergrößerung der Fläche A vor, was - wie unmittelbar erkennbar ist - direkt zu einer deutlichen Herabsetzung des thermischen Widerstands Rth insgesamt führt. Das heißt, bereits das Einbetten einer einzelnen Kupferschicht - möglichst in der Nähe der LEDs - führt bereits zu einer deutlichen Verbesserung der Wärmeableitung.

Vorzugsweise sind in die Leiterplatte mehrere Kupferschichten eingebettet, wie dies in Figur 2 gezeigt ist. Hierbei wird die Verteilung der Wärme über die Fläche der Leiterplatte hinweg gesehen nochmals optimiert. Dabei können zusätzlich auch an der den LEDs 2 gegenüberliegenden Seite, also an der Unterseite der Leiterplatte 1 Kupferflächen 26 ausgebildet sein, welche dann nach außen beziehungsweise zur Umgebung weisende Kühlflächen bilden. Über diese Flächen könnten jedoch auch Ankopplungen an zusätzliche Kühlkörper oder dergleichen vorgenommen werden.

Letztendlich können also mit Hilfe der vorliegenden Erfindung LED-Module verhältnismäßig kostengünstig realisiert werden. Im Vergleich zu bislang bekannten Lösungen kann dabei trotz der Kostenreduzierung die Ableitung der während des Betriebs entstehenden Wärme deutlich verbessert werden.

**Patentansprüche**

1. Anordnung zur Lichtabgabe (50) mit mindestens einem Leuchtmittel in Form einer LED (2) sowie einem Trägerelement (1), an dessen Oberfläche die LED (2) angeordnet ist,
wobei das Trägerelement (1) durch eine Mehrschicht-Leiterplatte gebildet ist, welche aus einem elektrisch isolierenden Basismaterial (20) sowie mehreren Kupferschichten (25) besteht,
von denen zumindest eine in das Basismaterial (20) eingebettet ist und als Wärmeleiter dient.

2. Anordnung zur Lichtabgabe nach Anspruch 1, **dadurch gekennzeichnet,**
**dass** eine Kupferschicht an der Oberfläche der Leiterplatte (1), an der sich die LED (2) befindet, angeordnet und strukturiert ist, um Leiterbahnen und/oder einen Kontaktierungsbereich (11) für die LED (2) zu bilden.

3. Anordnung zur Lichtabgabe nach Anspruch 1 oder 2, **dadurch gekennzeichnet,**
**dass** an der Oberfläche der Leiterplatte (1), an der sich die LED (2) befindet, mindestens eine weitere elektronische Komponente (5) angeordnet ist.

4. Anordnung zur Lichtabgabe nach einem der vorherigen Ansprüche, **dadurch gekennzeichnet,**
**dass** mindestens zwei Kupferschichten (25) in das Basismaterial (20) eingebettet sind.

5. Anordnung zur Lichtabgabe nach einem der vorherigen Ansprüche, **dadurch gekennzeichnet,**
**dass** die der LED (2) gegenüberliegende Seite der Leiterplatte (1) zumindest teilweise mit Kupfer bedeckt ist.

6. Anordnung zur Lichtabgabe nach einem der vorherigen Ansprüche, **dadurch gekennzeichnet,**
**dass** es sich bei dem Basismaterial (20) um FR-4 handelt.

Fig. 1

Fig. 2

LICHT
(25-40%)

LED

ELEKTRISCHE
LEISTUNG

WÄRME
(60-75%)

Fig. 3

102

103

110

105

101

Fig. 4
STAND DER TECHNIK

100

Europäisches
Patentamt

European
Patent Office

Office européen
des brevets

## EUROPÄISCHER RECHERCHENBERICHT

**Nummer der Anmeldung**

EP 15 17 3100

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DE 10 2012 202307 A1 (BUERK MOBATIME GMBH [DE]) 22. August 2013 (2013-08-22) * das ganze Dokument * ----- | 1-6 | INV. H05K1/02 F21V29/00 |
| Y | DE 103 51 826 A1 (CONTI TEMIC MICROELECTRONIC [DE]) 9. Juni 2005 (2005-06-09) * das ganze Dokument * ----- | 1-6 | |
| Y | DE 101 27 268 A1 (SIEMENS AG [DE]) 25. April 2002 (2002-04-25) | 1-5 | |
| A | * das ganze Dokument * ----- | 6 | |

**RECHERCHIERTE SACHGEBIETE (IPC)**

H05K
F21V

Der vorliegende Recherchenbericht wurde für alle Patentansprüche erstellt

| Recherchenort | Abschlußdatum der Recherche | Prüfer |
|---|---|---|
| Den Haag | 6. November 2015 | Zimmer, René |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    ..........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 15 17 3100

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-11-2015

| Im Recherchenbericht angeführtes Patentdokument | Datum der Veröffentlichung | Mitglied(er) der Patentfamilie | Datum der Veröffentlichung |
|---|---|---|---|
| DE 102012202307 A1 | 22-08-2013 | KEINE | |
| DE 10351826 A1 | 09-06-2005 | KEINE | |
| DE 10127268 A1 | 25-04-2002 | KEINE | |

EPO FORM P0461

Für nähere Einzelheiten zu diesem Anhang : siehe Amtsblatt des Europäischen Patentamts, Nr.12/82